Europäisches Patentamt

European Patent Office

Office européen des brevets

(19)

(11)  EP 0 881 772 B1

(12)  **FASCICULE DE BREVET EUROPEEN**

(45) Date de publication et mention
de la délivrance du brevet:
**30.01.2002  Bulletin 2002/05**

(51) Int Cl.$^7$: **H03K 23/66**, H03L 7/193

(21) Numéro de dépôt: **98401187.4**

(22) Date de dépôt: **18.05.1998**

(54) **Dispositif de division de fréquence à prédiviseur suivi d'un compteur programmable, prédiviseur et synthétiseur de fréquence correspondants**

Frequenzteilungsvorrichtung, bestehend aus einem Vorzähler gefolgt von einem programmierbaren Zähler und Anwendung in einem Frequenzsynthetisierer

Frequency dividing device comprising a predivider followed by a programmable counter and corresponding frequency synthesizer

(84) Etats contractants désignés:
**CH DE ES FI FR GB IT LI SE**

(30) Priorité: **29.05.1997  FR 9706591**

(43) Date de publication de la demande:
**02.12.1998  Bulletin 1998/49**

(73) Titulaire: **ALCATEL**
**75008 Paris (FR)**

(72) Inventeur: **Genest, Pierre**
**95430 Butry sur Oise (FR)**

(74) Mandataire: **El Manouni, Josiane et al**
**COMPAGNIE FINANCIERE ALCATEL Dépt.**
**Propr. Industrielle, 30, avenue Kléber**
**75116 Paris (FR)**

(56) Documents cités:
**EP-A- 0 171 162            WO-A-81/02371**
**DE-A- 3 126 317            US-A- 5 066 927**
**US-A- 5 614 869**

• **PATENT ABSTRACTS OF JAPAN vol. 011, no. 343 (E-555), 10 novembre 1987 & JP 62 122421 A (HITACHI LTD;OTHERS: 01), 3 juin 1987**
• **PATENT ABSTRACTS OF JAPAN vol. 8, no. 181 (E-261) [1618] , 21 août 1984 & JP 59 074734 A (CLARION K.K.), 27 avril 1984**

**Description**

Le domaine de l'invention est celui des dispositifs de division de fréquence.

Plus précisément, l'invention concerne un dispositif de division de fréquence du type comprenant un prédiviseur de fréquence (ou prescaler en langue anglaise) suivi d'un compteur programmable.

L'invention concerne également un synthétiseur de fréquence à boucle à verrouillage de phase (PLL) comprenant un tel dispositif de division de fréquence, ainsi que le prédiviseur en tant que tel.

On rappelle qu'un prédiviseur de fréquence est un dispositif destiné à être utilisé en amont d'un compteur programmable. Le dispositif de division de fréquence formé de l'ensemble de ces deux éléments doit assurer une division par un rang de division total choisi (noté D dans la suite de la description).

Le dispositif de l'invention peut notamment, mais non exclusivement, être mis en oeuvre dans un synthétiseur de fréquence à boucle à verrouillage de phase (PLL). En effet, un tel synthétiseur comprend un dispositif de division de fréquence permettant de diviser par D la fréquence de sortie $f_s$ du synthétiseur, de façon à obtenir la fréquence de boucle $f_b$. En d'autres termes, on a la relation : $f_b = f_s/D$.

On rappelle que cette fréquence de boucle $f_b$ constitue, avec la fréquence de comparaison $f_c$, l'une des deux entrées du comparateur de phase compris dans le synthétiseur de fréquence.

On rappelle également que la fréquence de sortie $f_s$ du synthétiseur est soit égale à, soit (pour des raisons précisées par la suite) n fois plus élevée que la fréquence radio. Cette fréquence radio est une fréquence de valeur variable dans une plage prédéterminée. Elle varie selon un pas dont la valeur correspond à la largeur d'un canal radio. En effet, il s'agit de pouvoir générer tous les canaux radio existants, et c'est précisément en jouant sur le rang de division total D du dispositif de division de fréquence que l'on peut passer d'un canal radio à l'autre.

Dans le cadre de la présente invention, on considère que le prédiviseur fonctionne avec un couple de rangs de division, noté k/k+1 et appelé couple de fonctionnement dans la suite de la description. Le prédiviseur comprend des moyens de basculement du rang de division le plus élevé k+1 au rang de division le plus faible k du couple de fonctionnement k/k+1, en fonction d'un signal de basculement (appelé "modulus control" en langue anglaise).

D'une façon générale, le rang de division total D d'un dispositif de division de fréquence peut s'écrire : D = k.N + A, où :

- N est une première valeur prédéterminée programmable correspondant au rang de division du compteur programmable, et
- A est une seconde valeur prédéterminée programmable telle que lorsqu'elle est atteinte par le compteur programmable, le prédiviseur reçoit le signal de basculement. Il est à noter que la relation $0 \leq A < N$ doit obligatoirement être vérifiée.

On s'aperçoit que les dispositifs de division de fréquence doivent pouvoir recevoir, et donc travailler à, des fréquences de plus en plus élevées.

Ainsi, il est maintenant fréquent que la fréquence de sortie $f_s$ d'un synthétiseur (qui est la fréquence que le dispositif de division de fréquence doit diviser par D de façon à obtenir la fréquence de boucle $f_b$) soit une fréquence n fois plus élevée que la fréquence radio. Ceci permet de résoudre les problèmes de blindage liés à la transposition directe, et d'améliorer le bruit de phase, sous réserve que la comparaison se fasse elle aussi à une fréquence multiple.

En d'autres termes, on utilise maintenant une fréquence de sortie $f_s$ du synthétiseur et une fréquence de comparaison $f_c$ toutes les deux multiples de celles utilisées auparavant (par exemple n fois plus élevées).

On explicite maintenant, dans le cas du GSM 900 ("Groupe Spécial systèmes Mobiles publics de radiocommunication fonctionnant dans la bande des 900 MHz") puis dans celui du DCS 1800 ("Digital Communication System" fonctionnant dans la bande des 1800 MHz), cette technique connue consistant à prendre des fréquences de sortie $f_s$ et de comparaison $f_c$ multiples de celles utilisées auparavant.

Dans le cas du standard GSM 900, la plage de fréquences radio est située autour des 900 MHz. En choisissant par exemple un synthétiseur délivrant une fréquence de sortie $f_s$ quatre fois plus élevée que la fréquence radio, soit $f_s$ = 4 x 900 MHz = 3,6 GHz, alors le synthétiseur présentera un bruit de phase beaucoup plus faible si la fréquence de comparaison est elle aussi quatre fois plus élevée que la fréquence de comparaison actuelle, soit $f_c$ = 4 x 200 kHz = 800 kHz.

Dans le cas du standard DCS 1800, la plage de fréquences radio est située autour des 1,8 GHz. En choisissant par exemple un synthétiseur délivrant une fréquence de sortie $f_s$ deux fois plus élevée que la fréquence radio, soit $f_s$ = 2 x 1 800 MHz = 3,6 GHz, alors le synthétiseur présentera un bruit de phase beaucoup plus faible si la fréquence de comparaison est elle aussi deux fois plus élevée que la fréquence de comparaison actuelle, soit $f_c$ = 2 x 200 kHz = 400 kHz.

Cette multiplication par n des fréquences de sortie $f_s$ et de comparaison $f_c$ est sans répercussion sur le rang de division total D que le dispositif de division doit appliquer pour un canal radio souhaité de la fréquence radio $f_r$. En effet, du fait que la fréquence de boucle $f_b$ converge vers la fréquence de comparaison $f_c$, prendre des fréquences de sortie $f_s$ et de comparaison $f_c$ n fois plus élevées qu'auparavant revient à prendre des fréquences de sortie $f_s$ et de boucle $f_b$ n fois plus élevées qu'auparavant. Par conséquent, pour obtenir un canal radio donné de la fréquence radio $f_r$, le rang

de division total D du dispositif de division est inchangé, puisque : $D = f_s/f_b = n.f_s/n.f_b$.

En revanche, cette multiplication par n des fréquences de sortie $f_s$ et de comparaison $f_c$ n'est pas sans répercussion en termes de matériel. En effet, la fréquence que reçoit le dispositif de division est multipliée par n. Par conséquent, du fait que le rang de division total D n'est pas affecté, deux solutions peuvent être envisagées :

- soit les deux rangs du couple de rangs de division k/k+1 du prédiviseur restent inchangés, et le rang de division du compteur programmable est multiplié par n,
- soit le couple de rangs de division k/k+1 du prédiviseur est multiplié par n (si n = 2, on prend par exemple le couple k'/k'+1 avec k' = 2.k), et le rang de division du compteur programmable reste inchangé.

Malheureusement, chacune de ces deux solutions présente des inconvénients.

Avec la première solution, le compteur programmable reçoit une fréquence n fois plus élevée que celle reçue actuellement. Ainsi, avec n = 2, la fréquence en entrée du compteur programmable passerait à 60 MHz au lieu de 30 MHz aujourd'hui. Or une telle augmentation de fréquence n'est pas toujours possible du fait que le compteur programmable, qui est généralement réalisé en CMOS, présente une vitesse de fonctionnement limitée. En d'autres termes, le compteur programmable est conçu pour un fonctionnement "basse fréquence". En tout état de cause, même si le compteur programmable peut accepter une telle augmentation de la fréquence qu'il reçoit, ce n'est qu'au prix d'un fort surcoût en consommation, et éventuellement de répercussions sur le bruit de la boucle à verrouillage de phase, en raison de la diminution du rapport entre la fréquence permise par la technologie et la fréquence effective de travail.

On cherche donc plutôt à augmenter les rangs de division du prédiviseur (seconde solution précitée). D'après la formule : D = k.N + A, A doit pouvoir varier de 0 à k-1 pour que tous les rangs de division D puissent être réalisés (c'est-à-dire pour que tous les canaux puissent être adressés). Or, du fait de la relation : $0 \le £ A < N$, A ne peut pas varier de 0 à k-1 si N < k-1 (puisque dans ce cas, on a : A < N < k-1). En d'autres termes, si N < k-1, il n'est pas possible de réaliser tous les rangs de division nécessaires.

Par exemple, avec k = 128, on a : $N_{min}$ = 64. De la formule : D = k.N + A et de la relation : $0 \le A \le N-1$, on déduit : $k.N \le D \le k.N + (N-1)$. Ainsi, en prenant des valeurs successives de N, à partir de $N_{min}$, on a :

- pour N = 64 : $8192 \le D \le 8255$ ;
  (il manque les rangs de division 8256 à 8319)
- pour N = 65 : $8320 \le D \le 8384$ ;

   (il manque les rangs de division 8385 à 8447)
- pour N = 66 : $8448 \le D \le 8513$ ;
- etc.

Ainsi, dans cet exemple, les rangs de division 8256 à 8319, 8385 à 8447, etc, ne sont pas réalisés.

En résumé, il apparaît que les dispositifs de division de fréquence actuels ne permettent pas de satisfaire l'exigence nouvelle de travailler avec des fréquences de plus en plus élevées.

L'invention a notamment pour objectif de pallier ces différents inconvénients de l'état de la technique.

Plus précisément, l'un des objectifs de la présente invention est de fournir un dispositif de division de fréquence, du type comprenant un prédiviseur suivi d'un compteur programmable, pouvant recevoir des fréquences très élevées.

L'invention a également pour objectif de fournir un tel dispositif qui évite d'augmenter la fréquence de fonctionnement du compteur programmable, tout en permettant de réaliser tous les rangs de division D nécessaires.

Ces différents objectifs, ainsi que d'autres qui apparaîtront par la suite, sont atteints selon l'invention à l'aide d'un dispositif de division de fréquence, du type comprenant un prédiviseur suivi d'un compteur programmable, et divisant une première fréquence par un rang de division total D pouvant s'écrire : D = k.N + A, de façon à obtenir une seconde fréquence,

ledit prédiviseur étant du type fonctionnant avec un couple de rangs de division, noté k/k+1, et comprenant des moyens de basculement du rang de division le plus élevé k+1 au rang de division le plus faible k dudit couple de fonctionnement k/k+1, en fonction d'un signal de basculement (modulus control),

N étant une première valeur prédéterminée programmable correspondant au rang de division dudit compteur programmable,

A étant une seconde valeur prédéterminée programmable telle que lorsqu'elle est atteinte par le compteur programmable, le prédiviseur reçoit ledit signal de basculement, la relation $0 \le A < N$ devant obligatoirement être vérifiée,

caractérisé en ce que ledit prédiviseur dispose d'au moins deux couples de rangs de division successifs, notés respectivement p/p+1, p+1/p+2, p+2/p+3, etc,

et en ce que ledit prédiviseur comprend des moyens de sélection dynamique de l'un desdits couples de rangs de division en fonction d'un signal de sélection, le couple sélectionné constituant ledit couple de fonctionnement k/k+1, ledit signal de sélection dépendant dudit rang de division total D que ledit dispositif de division de fréquence doit appliquer.

Le principe général de l'invention consiste donc à sélectionner de façon dynamique, en fonction du rang de division total D à appliquer, un couple de rangs de division du prédiviseur parmi plusieurs couples de rangs de division successifs.

Ainsi, même pour une fréquence à diviser très élevée (notamment n fois supérieure à celle utilisée auparavant, en reprenant la notation ci-dessus), il est possible de trouver des couples de rangs de division successifs du prédiviseur p/p+1, p+1/p+2, p+2/p+3, etc, tels que la fréquence de fonctionnement du compteur programmable n'a pas à être augmentée, et tels que tous les rangs de division D nécessaires peuvent être réalisés.

De façon avantageuse, N possède une valeur minimale $N_{min}$, telle que :

$$N_{min} = S(p/c), \text{ où:}$$

- p est le rang de division le plus faible du premier desdits couples de rangs de division successifs p/p+1, p+1/p+2, p+2/p+3, etc,
- S est une fonction telle que S(x) est le premier entier supérieur ou égal à x.
- c est le nombre de couples de rangs de division successifs p/p+1, p+1/p+2, p+2/p+3, etc.

Dans un mode de réalisation particulier de l'invention, ledit prédiviseur peut commuter de façon dynamique entre les deux couples de rangs de division successifs suivants : 127/128 et 128/129, en fonction dudit signal de sélection.

Ce mode de réalisation particulier de l'invention, comme décrit plus en détail dans la suite de la description, peut notamment être mis en oeuvre dans un synthétiseur de fréquence, pour une application au GSM 900, au DCS 1800, ou encore au PCS 1900.

L'invention concerne également un synthétiseur de fréquence, du type à boucle à verrouillage de phase, comprenant :

- un comparateur de phase, recevant d'une part une fréquence de comparaison $f_c$ obtenue à partir d'une fréquence d'horloge $f_h$ délivrée par un élément résonant, et d'autre part une fréquence de boucle $f_b$,
- un filtre de boucle, recevant la sortie dudit comparateur de phase,
- un oscillateur contrôlé en tension, recevant la sortie dudit filtre de boucle, et générant la fréquence de sortie $f_s$ dudit synthétiseur,
- des moyens de division programmables, divisant ladite fréquence de sortie $f_s$, de façon à obtenir ladite fréquence de boucle $f_b$,

caractérisé en ce que lesdits moyens de division programmables comprennent un dispositif de division de fréquence tel que précité, permettant de diviser ladite

fréquence de sortie $f_s$ par ledit rang de division total D, de façon à obtenir ladite fréquence de boucle $f_b$.

L'invention concerne aussi un prédiviseur de fréquence, du type destiné à être utilisé dans un dispositif de division de fréquence, caractérisé en ce qu'il dispose d'au moins deux couples de rangs de division successifs, notés respectivement p/p+1, p+1/p+2, p+2/p+3, etc, et en ce qu'il comprend des moyens de sélection dynamique de l'un desdits couples de rangs de division en fonction d'un signal de sélection, ledit signal de sélection dépendant dudit rang de division total D que ledit dispositif de division de fréquence doit appliquer.

D'autres caractéristiques et avantages de l'invention apparaîtront à la lecture de la description suivante d'un mode de réalisation préférentiel de l'invention, donné à titre d'exemple indicatif et non limitatif, et des dessins annexés, dans lesquels :

- la figure 1 présente un schéma synoptique d'un mode de réalisation particulier d'un synthétiseur de fréquence, pouvant comprendre un dispositif de division de fréquence selon l'invention ; et
- la figure 2 présente un mode de réalisation particulier d'un dispositif de division de fréquence selon l'invention.

L'invention concerne donc un dispositif de division de fréquence, du type comprenant un prédiviseur suivi d'un compteur programmable. Ce dispositif permet de diviser une première fréquence par un rang de division total D, de façon à obtenir une seconde fréquence. Comme expliqué en détail par la suite, le rang de division total D peut s'écrire : D = k.N + A.

Un tel dispositif de division de fréquence est par exemple mis en oeuvre dans un synthétiseur de fréquence à boucle à verrouillage de phase, ce synthétiseur étant par exemple lui-même compris dans un terminal de radiocommunication, notamment (mais non exclusivement) de type GSM 900, DCS 1800 ou PCS 1900.

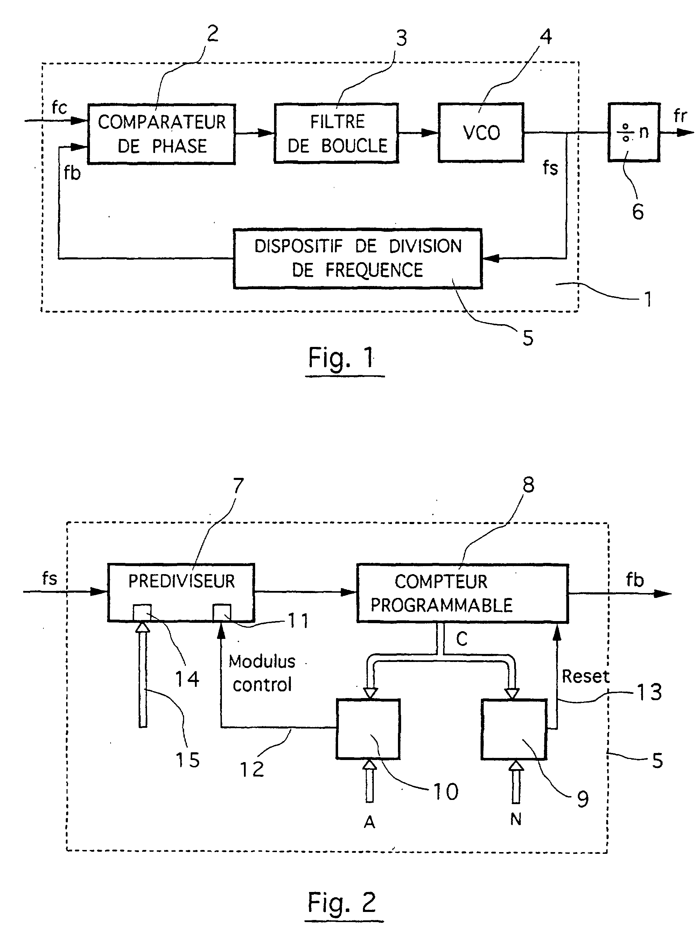

Comme présenté sur la figure 1, dans un mode de réalisation particulier, ce synthétiseur de fréquence 1 comprend :

- un comparateur de phase 2, qui reçoit une fréquence de comparaison $f_c$ et une fréquence de boucle $f_b$ (dont l'obtention est précisée ci-dessous) ;
- un filtre de boucle 3, dont l'entrée reçoit la sortie du comparateur de phase 2 :
- un oscillateur contrôlé en tension (ou VCO) 4, dont l'entrée reçoit la sortie du filtre de boucle 3, et qui génère la fréquence de sortie $f_s$ du synthétiseur 1 ;
- un dispositif de division de fréquence 5, qui génère la fréquence de boucle $f_b$ à partir de la fréquence de sortie $f_s$ du synthétiseur 1.

Généralement, la fréquence de comparaison $f_c$ est obtenue par division d'une fréquence d'horloge $f_h$

générée par un élément résonant (non représenté), tel que par exemple un oscillateur piézoélectrique commandé en fréquence, ou VCXO.

La fréquence de sortie $f_s$ est telle que $f_s = n.f_r$. avec n un nombre entier supérieur ou égal à 2 (généralement, n est une puissance de 2). On rappelle en effet que le fait que le synthétiseur de fréquence génère une fréquence de sortie $f_s$ multiple de la fréquence radio $f_r$, et non pas directement la fréquence radio $f_r$, permet notamment d'éliminer l'impact des couplages externes au dispositif, ce qui autorise un allègement des blindages en émission et une baisse de la tension de décalage en réception.

Des moyens 6 de division, placés en aval du synthétiseur 1, permettent d'assurer une division par n de la fréquence de sortie $f_s$ du synthétiseur 3, de façon à obtenir la fréquence radio $f_r$.

Grâce à la boucle à verrouillage de phase, la fréquence de boucle $f_b$ converge vers la fréquence de comparaison $f_c$. Par conséquent, en fonction du rang de division total D choisi pour le dispositif de division 5, le synthétiseur génère une fréquence de sortie $f_s$ qui converge vers : $D.f_c$. En d'autres termes, en faisant varier D, on peut adresser tous les canaux radio. En fait, comme : $f_s = n.f_r$, pour une valeur de $f_r$ souhaitée (correspondant un canal radio particulier), on choisit D tel que : $D = n.f_r/f_c$.

Ainsi, dans le cas du DCS 1800, on prend par exemple le VCO 4 (c'est-à-dire la fréquence de sortie $f_s$) dans une plage située autour des 3,6 GHz, et la fréquence de comparaison $f_c$ égale à 400 kHz (soit n.200 kHz, avec n = 2, n étant le rapport $f_s/f_r$). On rappelle en outre que, dans ce cas, la plage de fréquences radio $f_s$ est située autour des 1,8 GHz (plus précisément, 1710-1785 MHz pour le sens montant et 1805-1880 MHz pour le sens descendant). Enfin, chaque canal a une largeur de 200 kHz, et il y a donc 374 canaux dans chaque sens.

En reprenant l'exemple précité, pour adresser le premier canal (centré sur $f_r$ = 1710 MHz) du sens montant du DCS 1800, on choisit : $D = n.f_r/f_c$ = 2 x 1710 MHz / 400 kHz = 8550. De même, pour adresser le dernier canal du sens montant (centré sur $f_r$ = 1785 MHz), on choisit : $D = n.f_r/f_c$ = 2 x 1785 MHz / 400 kHz = 8925. Le dispositif de division de fréquence 5 doit donc pouvoir générer tous les rangs de division D compris entre 8550 et 8925 pour que tous les canaux du sens montant du DCS 1800 puissent être adressés.

Il est clair qu'il existe différentes plages dans lequelles doit pouvoir varier le rang de division D, ces plages étant fonction du sens (montant ou descendant) des canaux à adresser, du rapport n entre $f_s$ et $f_r$, et du standard adopté (GSM 900, DCS 1800, PCS 1900, ...).

On présente maintenant, en relation avec la figure 2, un mode de réalisation particulier du dispositif de division de fréquence selon l'invention. Dans la suite de la description, on considère que le dispositif de division de fréquence est celui référencé 5 sur la figure 1 et est donc destiné à être mis en oeuvre dans le synthétiseur de fréquence 1.

Il est clair cependant que le dispositif de l'invention peut s'appliquer dans d'autres cas, et plus généralement dans tous les cas où un rang de division D élevé doit être réalisé, sans pour autant que la partie basse fréquence (c'est-à-dire le compteur programmable) soit modifiée.

De façon classique, le dispositif de division de fréquence 5 comprend un prédiviseur 7, un compteur programmable 8 et un premier et un second comparateurs 9 et 10. On rappelle ci-dessous le rôle et le fonctionnement de ces éléments.

Lorsque le premier comparateur 9 détecte l'arrivée de la valeur courante C du compteur programmable 8 à une première valeur prédéterminée programmable N, il génère un signal ("reset") 13 de remise à zéro du compteur programmable 8. Ainsi, la première valeur prédéterminée programmable N correspond au rang de division du compteur programmable 8.

Lorsque le second comparateur 10 détecte l'arrivée de la valeur courante C du compteur programmable 8 à une seconde valeur prédéterminée programmable A, il génère un signal ("modulus control") 12 de basculement dont le rôle est précisé ci-dessous.

Il est à noter que la relation $0 \le A < N$ doit obligatoirement être vérifiée.

Le prédiviseur 7 est du type fonctionnant avec un couple de rangs de division, noté k/k+1. Il comprend des moyens 11 de basculement du rang de division le plus élevé k+1 au rang de division le plus faible k, lorsqu'il reçoit le signal de basculement (modulus control) 12. Le signal de basculement correspond par exemple passage d'un bit de 0 à 1.

En d'autres termes, le prédiviseur 7 divise par k+1 jusqu'à ce que le compteur programmable arrive à A, puis par k jusqu'à ce que le compteur programmable arrive à N. Le rang de division D du compteur programmable 8 peut donc s'écrire : $D = (k+1).A + k.(N-A) = k.N + A$.

Selon la présente invention, le prédiviseur 7 dispose d'au moins deux couples de rangs de division successifs, notés respectivement p/p+1, p+1/p+2, p+2/p+3, etc. Par ailleurs, le prédiviseur 7 comprend des moyens 14 de sélection dynamique de l'un des couples de rangs de division en fonction d'un signal de sélection 15.

Le couple sélectionné constitue le couple de fonctionnement k/k+1. Le signal de sélection 15 dépend du rang de division total D que le dispositif de division de fréquence 5 doit appliquer.

Avec l'invention, on a donc autant de formules du type : $D = k.N + A$, que de couples distincts de rangs de divisions pouvant être sélectionnés. En effet, on a les formules suivantes :

- $D = p.N + A$, si le couple p/p+1 est sélectionné,
- $D = (p+1).N + A$, si le couple p+1/p+2 est sélectionné,

- D = (p+2).N + A,     si le couple p+2/p+3 est sélectionné,
- etc.

Ainsi, en fonction du canal radio à adresser, c'est-à-dire en fonction du rang de division D à réaliser, les valeurs A et N sont programmées (par exemple par un microcontrôleur) et, en outre, l'un des couples de rangs de division successifs, p/p+1, p+1/p+2, p+2/p+3, etc, est sélectionné.

A titre de comparaison, on rappelle que dans les dispositifs de division de fréquence connus, le prédiviseur n'utilise qu'un seul et unique couple de rangs de division. Par conséquent, il suffit de programmer les valeurs A et N.

Afin que la plage de valeurs du rang de division D ne présente pas d'interruption, la valeur N doit posséder une valeur minimale $N_{min}$, telle que : $N_{min} = S(p/c)$, où :

- p est le rang de division le plus faible du premier des couples de rangs de division successifs p/p+1, p+1/p+2, p+2/p+3, etc,
- S est une fonction telle que S(x) est le premier entier supérieur ou égal à x,
- c est le nombre de couples de rangs de division successifs p/p+1, p+1/p+2, p+2/p+3, etc.

Par exemple, avec c = 2 et p = 127 (c'est-à-dire avec un prédiviseur disposant des deux couples 127/128 et 128/129), on trouve $N_{min} = 64$. Dans un but explicatif, on vérifie ci-dessous que, dans cet exemple, 64 est bien la valeur minimale de N et que tous les rangs de division D peuvent être réalisés :

- pour N = 63, avec le couple 127/128, on a: $8001 \leq D \leq 8063$ ;
  avec le couple 128/129, on a :     $8064 \leq D \leq 8126$ ;
      (il manque le rang de division D = 8127)
- pour N = 64, avec le couple 127/128, on a: $8128 \leq D \leq 8191$ ;
  avec le couple 128/129, on a:     $8192 \leq D \leq 8255$;
      (il ne manque aucun rang de division D)
- pour N = 65, avec le couple 127/128, on a : $8255 \leq D \leq 8319$ ;
  avec le couple 128/129, on a:     $8320 \leq D \leq 8384$;
      (il ne manque aucun rang de division D)
- pour N = 66, avec le couple 127/128. on a: $8382 \leq D \leq 8447$ ;
  avec le couple 128/129, on a :     $8448 \leq D \leq 8513$;
- etc.

Il est clair à travers cet exemple que si pour N

$\geq 64$, tous les rangs de division D peuvent être réalisés, ce n'est pas le cas pour N < 64.

Il est à noter qu'avec les deux couples précités, à savoir 127/128 et 128/129, il est possible de réaliser tous les rangs de division à partir de 8128. Ceci permet d'adresser notamment :

- tous les canaux du GSM 900, avec une fréquence de sortie du synthétiseur $f_s$ dans une plage située autour des 3,6 GHz (soit $f_s = 4.f_r$), et une fréquence de comparaison $f_c$ égale à 400 kHz ;
- tous les canaux du DCS 1800, avec une fréquence de sortie du synthétiseur $f_s$ dans une plage située autour des 3.6 GHz (soit $f_s = 2.f_r$), et une fréquence de comparaison $f_c$ égale à 400 kHz.

Il est clair cependant que l'invention n'est pas limitée à ce mode de réalisation particulier, et peut notamment s'appliquer avec d'autres valeurs de p et/ou avec plus de deux couples de rangs de division successifs.

## Revendications

**1.**  Dispositif de division de fréquence (5), du type comprenant un prédiviseur (7) suivi d'un compteur programmable (8), et divisant une première fréquence ($f_s$) par un rang de division total D pouvant s'écrire : D = k.N + A, de façon à obtenir une seconde fréquence ($f_b$),

ledit prédiviseur (7) étant du type fonctionnant avec un couple de rangs de division, noté k/k+1, et comprenant des moyens (11) de basculement du rang de division le plus élevé k+1 au rang de division le plus faible k dudit couple de fonctionnement k/k+1. en fonction d'un signal de basculement (12).

N étant une première valeur prédéterminée programmable correspondant au rang de division dudit compteur programmable (8),

A étant une seconde valeur prédéterminée programmable telle que lorsqu'elle est atteinte par le compteur programmable (8), le prédiviseur (7) reçoit ledit signal de basculement (12), la relation $0 \leq A < N$ devant obligatoirement être vérifiée,

**caractérisé en ce que** ledit prédiviseur (7) dispose d'au moins deux couples de rangs de division successifs, notés respectivement p/p+1, p+1/p+2, p+2/p+3, etc,

et **en ce que** ledit prédiviseur (7) comprend des moyens (14) de sélection dynamique de l'un desdits couples de rangs de division en fonction d'un signal de sélection (15), le couple sélectionné constituant ledit couple de fonctionnement k/k+1, ledit signal de sélection dépendant dudit rang de division total D que ledit dispositif de division de fréquence (5) doit appliquer.

2. Dispositif selon la revendication 1, **caractérisé en ce que** N possède une valeur minimale N$_{min}$, telle que : N$_{min}$ = S(p/c), où :

   - p est le rang de division le plus faible du premier desdits couples de rangs de division successifs p/p+1, p+1/p+2, p+2/p+3, etc,
   - S est une fonction telle que S(x) est le premier entier supérieur ou égal à x,
   - c est le nombre de couples de rangs de division successifs p/p+1, p+1/p+2, p+2/p+3, etc.

3. Dispositif selon l'une quelconque des revendications 1 et 2, **caractérisé en ce que** ledit prédiviseur (7) peut commuter de façon dynamique entre les deux couples de rangs de division successifs suivants : 127/128 et 128/129, en fonction dudit signal de sélection (15).

4. Synthétiseur de fréquence (1), du type à boucle à verrouillage de phase. comprenant :

   - un comparateur de phase (2), recevant d'une part une fréquence de comparaison f$_c$ obtenue à partir d'une fréquence d'horloge f$_h$ délivrée par un élément résonant, et d'autre part une fréquence de boucle f$_b$,
   - un filtre de boucle (3), recevant la sortie dudit comparateur de phase,
   - un oscillateur contrôlé en tension (4), recevant la sortie dudit filtre de boucle, et générant la fréquence de sortie f$_s$ dudit synthétiseur,
   - des moyens (5) de division programmables, divisant ladite fréquence de sortie f$_s$, de façon à obtenir ladite fréquence de boucle f$_b$,

   **caractérisé en ce que** lesdits moyens (5) de division programmables comprennent un dispositif de division de fréquence selon l'une quelconque des revendications 1 à 3, permettant de diviser ladite fréquence de sortie f$_s$ par ledit rang de division total D, de façon à obtenir ladite fréquence de boucle f$_b$.

5. Prédiviseur de fréquence (7), du type destiné à être utilisé dans un dispositif de division de fréquence (5) selon l'une quelconque des revendications 1 à 3, **caractérisé en ce qu'**il dispose d'au moins deux couples de rangs de division successifs, notés respectivement p/p+1, p+1/p+2, p+2/p+3, etc, et **en ce qu'**il comprend des moyens (14) de sélection dynamique de l'un desdits couples de rangs de division en fonction d'un signal de sélection (15), le couple sélectionné constituant ledit couple de fonctionnement k/k+1, ledit signal de sélection dépendant dudit rang de division total D que ledit dispositif de division de fréquence doit appliquer.

**Patentansprüche**

1. Frequenzteilungsvorrichtung (5), der Art, die einen Vorteiler (7) umfaßt, gefolgt von einem programmierbaren Zähler (8) und die eine erste Frequenz (f$_s$) durch eine totale Teilungsreihe (D) teilt, die geschrieben werden kann als: D = k.N + A, um eine zweite Frequenz (f$_b$) zu erhalten,
   wobei der Vorteiler (7) von der Art ist, die mit einer Teilungsreihenpaarung arbeitet, bezeichnet als k/k+1, und Einrichtungen (11) zum Schalten von der höheren Teilungsreihe k+1 zur kleineren Teilungsreihe k der Funktionspaarung k/ k+1 umfaßt, als Funktion eines Schaltsignales (12),
   wobei N ein erster programmierbarer vorbestimmter Wert ist, der mit der Teilungsreihe des programmierbaren Zählers (8) korrespondiert,
   wobei A ein zweiter programmierbarer vorbestimmter Wert ist, so daß, wenn dieser durch den programmierbaren Zähler (8) erreicht wird, der Vorteiler (7) das Schaltsignal (12) erhält, wobei die Relationen 0 ≤ A ≤ N obligatorisch verifiziert sein muß, **dadurch gekennzeichnet, daß** der Vorteiler (7) zumindest zwei aufeinander folgende Teilungsreihenpaarungen anordnet, bezeichnet jeweils als p/ p+1, p+1/p+2, p+2/p+3 , etc.,
   und dadurch, daß der Vorteiler (7) Einrichtung (14) zur dynamischen Auswahl einer der Teilungsreihenpaarungen als Funktion eines Selektionssignales (15) umfaßt, wobei die gewählte Paarung die Funktionspaarung k/k+1 bildet, wobei das Selektionssignal von der totalen Teilungsreihe D abhängt, die die Frequenzteilungsvorrichtung (5) anwenden muß.

2. Vorrichtung nach Anspruch 1, **dadurch gekennzeichnet, daß** N einen Minimalwert N$_{Min}$ besitzt, wie: N$_{Min}$ = S(p/c), wobei:

   - p die kleinste Teilungsreihe der ersten aufeinanderfolgenden Teilungsreihenpaarungen p/ p+1, p+1/p+2, p+2/p+3, etc. ist,

   - wobei S eine Funktion ist, wobei S(x) die erste ganzzahlige größer oder gleich x ist,

   - wobei C die Zahl der aufeinanderfolgenden Teilungsreihenpaarungen p/p+1, p+1/p+2, p+2/p+3, etc. ist.

3. Vorrichtung nach einem der Ansprüche 1 und 2, **dadurch gekennzeichnet, daß** der Vorteiler (7) in dynamischer Weise zwischen den zwei aufeinanderfolgenden Teilungsreihenpaarungen 127/ 128 und 128/ 129 kommutieren kann, als Funktion des Selektionssignales (15).

4.  Frequenzaufbereiter (1), der Art, die eine Phasenverriegelungsschleife aufweist, umfassend:

    -   einen Phasenvergleicher (2), der einerseits eine Vergleichsfrequenz $f_c$ aufnimmt, die auf der Basis einer Taktfrequenz $f_c$ erzeugt wird, abgegeben von einem Resonanzelement, und andererseits eine Schleifenfrequenz $f_b$,

    -   einen Schleifenfilter (3), der das Ausgangssignal des Phasenvergleichers aufnimmt,

    -   einen spannungsgesteuerten Oszillator (4), der das Ausgangssignal des Schleifenfilters aufnimmt, und die Ausgangsfrequenz $f_s$ des Aufbereiters generiert,

    -   Einrichtungen (5) zur programmierbaren Teilung, die die Ausgangsfrequenz $f_s$ in einer Weise teilen, um die Schleifenfrequenz $f_b$ zu erzeugen,

    **dadurch gekennzeichnet, daß** die Einrichtung (5) zur programmierbaren Teilung eine Frequenzteilungsvorrichtung nach einem der Ansprüche 1 bis 3 umfassen, was die Teilung der Ausgangsfrequenz $f_s$ durch die totale Teilungsreihe D ermöglicht, um die Schleifenfrequenz $f_b$ zu erzeugen.

5.  Frequenzvorteiler (7), der Art, die dazu bestimmt ist, in einer Frequenzteilungsvorrichtung (5) nach einem der Ansprüche 1 bis 3 verwendet zu werden, **dadurch gekennzeichnet, daß** er zumindest zwei aufeinander folgende Teilungsreihenpaarungen anordnet, jeweils bezeichnet als p/p+1, p+1/p+2, p+2/p+3, etc., und dadurch, daß er Einrichtungen (14) zur dynamischen Selektion einer der Teilungsreihenpaarungen als Funktion eines Selektionssignales (15) umfaßt, wobei die gewählte Paarung die Funktionspaarung k/k+1 bildet, wobei das Selektionssignal von der totalen Teilungsreihe D abhängt, welche die Frequenzteilungsvorrichtung anwenden muß.

## Claims

1.  A frequency divider (5) of the type comprising a prescaler (7) followed by a programmable counter (8), and serving to divide a first frequency ($f_s$) by an overall division ratio D that can be written D = k.N + A, so as to obtain a second frequency ($f_b$),

    said prescaler (7) being of the type that operates with a pair of division ratios, written k & k+1, and including means (11) for changeover from the higher division ratio k+1 to the lower division ratio k of said operating pair k & k+1 as a function of a modulus control signal (12),

    N being a first predetermined programmable value corresponding to the division ratio of said programmable counter (8), and

    A being a second predetermined programmable value such that on being reached by the programmable counter (8), the prescaler (7) receives said modulus control signal (12), with the relationship $0 \le A < N$ necessarily being satisfied;

    the divider being **characterized in that** said prescaler (7) has at least two successive pairs of division ratios, written respectively p & p+1, p+1 & p+2, p+2 & p+3, etc., and

    **in that** said prescaler (7) includes selection means (14) for dynamically selecting one of said pairs of division ratios as a function of a selection signal (15), the selected pair constituting said operating pair k & k+1, said selection signal depending on said overall division ratio D that said frequency divider (5) is to apply.

2.  A divider according to claim 1, **characterized in that** N has a minimum value $N_{min}$, such that: $N_{min} = S(p/c)$, where:

    ·   p is the smaller division ratio of the first of said successive pairs of division ratios p & p+1, p+1 & p+2, p+2 & p+3, etc.;
    ·   S is a function such that S(x) is the first integer greater than or equal to $\underline{x}$; and
    ·   $\underline{c}$ is the number of successive pairs of division ratios p & p+1, p+1 & p+2, p+2 & p+3, etc.

3.  A divider according to claim 1 or 2, **characterized in that** said prescaler (7) can switch dynamically between the following two successive pairs of division ratios: 127 & 128, and 128 & 129, as a function of said selection signal (15).

4.  A frequency synthesizer (1) of the phase-locked loop type, the synthesizer comprising:

    ·   a phase comparator (2) receiving both a loop frequency $f_b$ and a comparison frequency $f_c$ which is obtained from a clock frequency $f_h$ as delivered by a resonant element;
    ·   a loop filter (3) receiving the output from said phase comparator;
    ·   a voltage controlled oscillator (4) receiving the output from said loop filter, and generating the output frequency $f_s$ of said synthesizer; and
    ·   programmable divider means (5) dividing said output frequency $f_s$ to obtain said loop frequency $f_b$;

 the synthesizer being **characterized in that** said programmable divider means (5) comprise a frequency divider according to any one of claims 1 to 3 enabling said output frequency $f_s$ to be divided by said overall division ratio D so as to obtain said loop frequency $f_b$.

5. A frequency prescaler (7) of the type designed to be used in a frequency divider (5) according to any one of claims 1 to 3,

 the prescaler being **characterized in that** it has at least two successive pairs of division ratios respectively written p & p+1, p+1 & p+2, p+2 & p+3, etc.; and

 **in that** it includes selection means (14) for dynamically selecting one of said pairs of division ratios as a function of a selection signal (15), the selected pair constituting said operating pair k & k+1, said selection signal depending on the overall division ratio D that the frequency divider is to apply.

Fig. 1

Fig. 2